# FASCICULE DE BREVET EUROPEEN

(11) **EP 1 228 522 B1**
(45) Date de publication et mention de la délivrance du brevet: **31.08.2005**
(21) Numéro de dépôt: 00971478.3
(22) Date de dépôt: 23.10.2000
(51) Int. Cl.: H01J 37/32, C23C 16/04

(54) **CIRCUIT DE VIDE POUR UN DISPOSITIF DE TRAITEMENT D'UN RECIPIENT A L'AIDE D'UN PLASMA A BASSE PRESSION**
VAKUUMSYSTEM FÜR EINE VORRICHTUNG ZUR BEHANDLUNG EINES BEHÄLTERS MITTELS NIEDERDRUCKPLASMA
VACUUM CIRCUIT FOR A DEVICE FOR TREATING A RECEPTACLE WITH LOW PRESSURE PLASMA

(30) Priorité: 25.10.1999 FR 9913638
(43) Date de publication de la demande: 07.08.2002
(73) Titulaire: Sidel Actis Services, 76053 Le Havre Cedex (FR)
(72) Inventeur: RIUS, Jean-Michel, 76053 Le Havre Cedex (FR)
(74) Mandataire: Siloret, Patrick
(86) Numéro de dépôt international: PCT/FR2000/002941
(87) Numéro de publication internationale: WO 2001/031680

(56) Documents cités:
- WO-A-95/22413
- DE-A- 19 802 333
- FR-A- 2 776 540

## Description

L'invention se rapporte au domaine des dispositifs pour le traitement d'un récipient à l'aide d'un plasma à basse pression dans lesquels le plasma est créé par excitation d'un gaz grâce à des ondes électromagnétiques.

Un tel dispositif est par exemple décrit dans la demande de brevet WO99/49991 du même demandeur, à laquelle on pourra se reporter pour tout éclaircissement concernant les procédés susceptibles d'être mis en oeuvre grâce au dispositif selon l'invention. Dans le dispositif décrit dans le document cité ci-dessus. il est prévu que chaque récipient est pris en charge dans un poste de traitement comportant une cavité étanche et une enceinte externe. Le poste est pourvu d'un couvercle supérieur mobile qui permet d'ouvrir la cavité afin de pouvoir y introduire un récipient à traiter. En position de fermeture, le couvercle ferme cette cavité de manière étanche afin de pouvoir obtenir dans la cavité la basse pression nécessaire à la création d'un plasma dit froid. Avantageusement, le couvercle du dispositif comporte des moyens de support du récipient de manière que l'introduction et l'extraction du récipient soient assurés par le déplacement du couvercle entre ses positions d'ouverture et de fermeture.

Le dispositif décrit dans le document WO99/49991 est un dispositif dans lequel le traitement par plasma basse pression a pour but d'effectuer un dépôt de matière sur les parois du récipient. Pour cela, il est nécessaire d'apporter dans la cavité de traitement un gaz précurseur qui sera ionisé sous forme d'un plasma. Avantageusement, ledit document prévoit donc que les moyens d'injection du gaz précurseur comportent un injecteur monté sur le couvercle de la cavité.

Par ailleurs, pour atteindre la basse pression nécessaire à l'établissement d'un plasma, la cavité doit être reliée à des moyens de pompage par un circuit dit circuit de vide. Là encore, le document cité ci-dessus prévoit que l'extrémité de ce circuit de vide soit agencée sur le couvercle pour déboucher directement dans la cavité.

Cependant, ce document ne décrit pas de manière particulière les moyens qui permettent de relier le couvercle au circuit de vide.

L'invention a donc pour but de proposer une conception particulière du circuit de vide qui permette un fonctionnement parfaitement fiable de la machine incorporant ce dispositif.

Dans ce but, l'invention propose un dispositif de traitement du type décrit précédemment, caractérisé en ce que le couvercle comporte un canal de liaison qui, lorsque le couvercle est en position de fermeture étanche de la cavité, met en communication la cavité avec une extrémité fixe du circuit de vide.

Selon d'autres caractéristiques de l'invention :
- le canal de liaison comporte une extrémité de jonction, qui coopère avec l'extrémité fixe du circuit de vide, et deux terminaisons qui débouchent dans une face intérieure du couvercle qui délimite la cavité lorsque le couvercle est en position de fermeture, et les moyens de support sont prévus pour plaquer de manière étanche une ouverture du récipient à traiter contre ladite face intérieure du couvercle, l'ouverture entourant complètement une première des dites terminaisons de manière que le récipient délimite dans la cavité une première partie reliée au circuit de vide par la première terminaison et une seconde partie reliée au circuit de vide par la seconde des dites terminaisons ;
- l'une des deux terminaisons comporte un obturateur commandé pour pouvoir séparer de manière étanche les deux parties de la cavité lorsque le couvercle est en position de fermeture ;
- l'obturateur est une soupape commandée ;
- la première terminaison du canal de liaison permet le passage d'un injecteur pour amener un gaz réactif à l'intérieur du récipient ; et
- le canal de liaison comporte un orifice de reprise d'air qui débouche à l'air libre et qui est muni d'un volet d'obturation commandé pour pouvoir relier la cavité à l'atmosphère en fin de traitement.

D'autres caractéristiques et avantages de l'invention apparaîtront à la lecture de la description détaillée qui suit ainsi que dans les dessins annexés dans lesquels :
- la figure 1 est une vue schématique en coupe axiale d'une machine incorporant un dispositif de traitement selon l'invention dont le couvercle est illustré en position d'ouverture ;
- la figure 2 est une vue similaire à celle de la figure 1 dans laquelle le couvercle est illustré en position de fermeture de la cavité ;
- la figure 3 est une vue schématique en perspective éclatée de différents composants d'un poste de traitement selon l'invention ;
- la figure 4 est une vue schématique en plan du couvercle selon l'invention ;
- la figure 5 est une vue schématique en section selon la ligne 5-5 de la figure 4 illustrant les deux terminaisons du canal de liaison ;
- la figure 6 est une vue schématique en coupe illustrant les moyens de commande de la soupape de commande du différentiel de pression entre l'intérieur et l'extérieur du récipient.

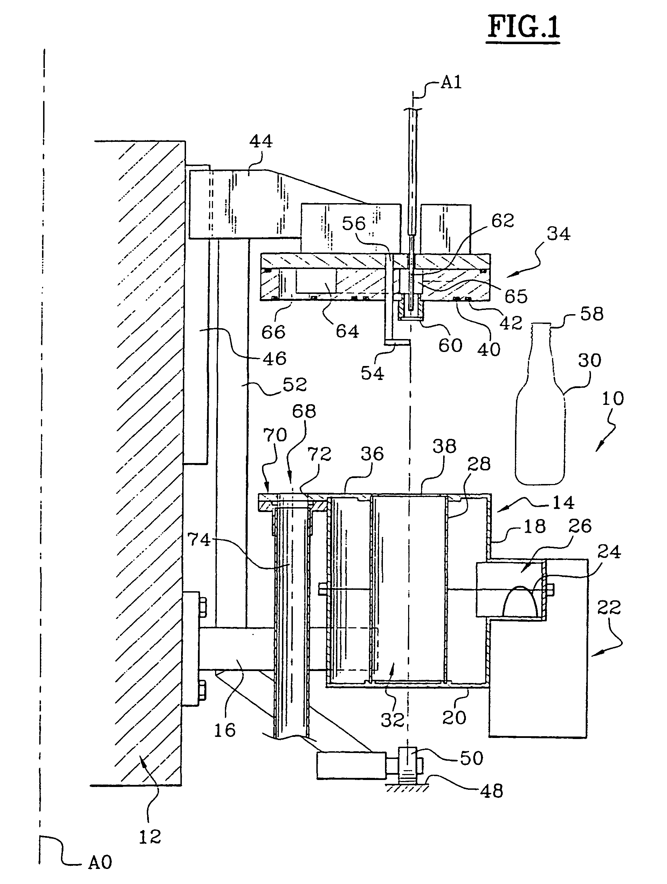

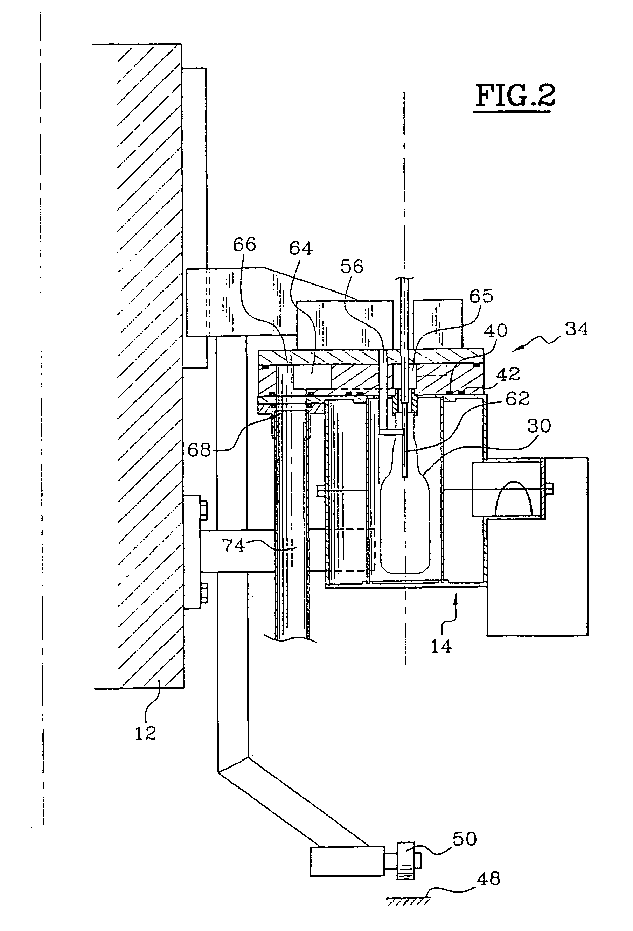

On a illustré sur les figures 1 et 2 des vues schématiques en coupe axiale d'un poste de traitement 10 conforme aux enseignements de l'invention. Le poste 10 fait ici partie d'une machine rotative comportant un carrousel 12 animé d'un mouvement continu de rotation autour d'un axe A0 vertical. Le carrousel 12 est donc prévu pour porter à sa périphérie une série de postes de traitement 10 identiques à celui illustré, les postes étant répartis angulairement de manière régulière autour de l'axe A0.

Le poste de traitement 10 comporte une enceinte externe 14 qui est fixée par un support radial 16 à la périphérie du carrousel 12. L'enceinte 14 est réalisée en matériau conducteur de l'électricité, par exemple en métal, et elle est formée d'une paroi cylindrique tubulaire 18 d'axe A1 vertical. L'enceinte est fermée à son extrémité inférieure par une paroi inférieure de fond 20.

A l'extérieur de l'enceinte 14, fixé à celle-ci, on trouve un boîtier 22 qui comporte des moyens (non représentés) pour créer à l'intérieur de l'enceinte 14 un champ électromagnétique apte à générer un plasma. En l'occurrence, il peut s'agir de moyens aptes à générer un rayonnement électromagnétique dans le domaine UHF, c'est-à-dire dans le domaine des micro-ondes. Dans ce cas, le boîtier 22 peut donc renfermer un magnétron dont l'antenne 24 débouche dans un guide d'onde 26. Ce guide d'onde 26 est par exemple un tunnel de section rectangulaire qui s'étend selon un rayon par rapport à l'axe A0 et qui débouche directement à l'intérieur de l'enceinte 14, au travers de la paroi latérale 18. Toutefois, l'invention pourrait aussi être mise en oeuvre dans le cadre d'un dispositif muni d'un source de rayonnement de type radiofréquence, et/ou la source pourrait aussi être agencée différemment, par exemple à l'extrémité axiale inférieure de l'enceinte 14.

A l'intérieur de l'enceinte 14, on trouve un tube 28 d'axe A1 qui est réalisé avec un matériau transparent pour les ondes électromagnétiques introduites dans l'enceinte 14 via le guide d'onde 26. On peut par exemple réaliser le tube 28 en quartz. Ce tube 28 est destiné à recevoir un récipient 30 à traiter. Son diamètre interne doit donc être adapté au diamètre du récipient. Il doit de plus délimiter une cavité 32 dans laquelle il sera créé une dépression de l'ordre de 10⁻⁴ bar une fois le récipient à l'intérieur de l'enceinte.

Comme on peut le voir sur la figure 1, l'enceinte 14 est partiellement refermée à son extrémité supérieure par une paroi supérieure 36 qui est pourvue d'une ouverture centrale 38 de diamètre sensiblement égal au diamètre du tube 28 de telle sorte que le tube 28 soit totalement ouvert vers le haut pour permettre l'introduction du récipient 30 dans la cavité 32. Au contraire, on voit que la paroi inférieure métallique 20, à laquelle l'extrémité inférieure du tube 28 est reliée de manière étanche, forme le fond de la cavité 32.

Pour refermer l'enceinte 14 et la cavité 32, le poste de traitement 10 comporte donc un couvercle 34 qui est mobile axialement entre une position haute illustrée à la figure 1 et une position basse de fermeture illustrée à la figure 2. En position haute, le couvercle est suffisamment dégagé pour permettre l'introduction du récipient 30 dans la cavité 32.

En position de fermeture, illustrée à la figure 2, le couvercle 34 vient en appui de manière étanche contre la face supérieure de la paroi supérieure 36 de l'enceinte 14. Comme l'extrémité supérieure du tube 28 est reliée de manière étanche à la paroi supérieure 36, le couvercle 34 est à même de fermer de manière étanche la cavité 32. Il est prévu pour cela un joint d'étanchéité 40, de type joint torique, qui est porté par le couvercle 34 et qui vient en appui sur la paroi supérieure 36 de la cavité 14 autour de l'orifice central 38.

Par ailleurs, le couvercle 34 comporte aussi un jonc conducteur souple 42, par exemple réalisé sous la forme d'une tresse métallique, qui vient aussi en appui contre la paroi 36 de manière à assurer une liaison électrique entre l'enceinte 14 et le couvercle 34 lorsque ce dernier est en position de fermeture. En effet, le couvercle est réalisé en matériau conducteur et il a aussi comme fonction de fermer l'enceinte 14 pour permettre l'établissement, à l'intérieur de celle-ci, d'un champ électromagnétique apte à créer un plasma dans la cavité 32. De manière avantageuse, ce jonc peut être réalisé à base d'un matériau souple (type silicone) chargé de particules métalliques pour être conducteur de l'électricité. En effet, un tel jonc peut jouer à la fois le rôle de joint d'étanchéité et celui de liaison électrique entre le couvercle et l'enceinte 14.

Dans l'exemple illustré, le couvercle 34 coulisse verticalement par rapport à l'enceinte 14. A cet effet, il est porté par un chariot 44 qui coulisse sur une glissière 46 solidaire du carrousel 12. Cependant, on pourrait envisager que le couvercle 34 ait un autre mouvement relatif par rapport à la cavité 14 entre ses positions d'ouverture et de fermeture, par exemple un mouvement de pivotement autour d'un axe horizontal.

Dans l'exemple illustré, on profite du fait que le poste de traitement soit monté sur un carrousel rotatif pour commander les déplacements du couvercle à l'aide d'un système à came 48 et à galet 50. En effet, la machine comporte une came fixe 48 qui s'étend en arc de cercle autour de l'axe A0 et dont une face supérieure forme une piste de roulement. Bien entendu, la hauteur de la came 48 varie en fonction de la position angulaire autour de l'axe A0.

Le galet 50 est relié au chariot 44 qui porte le couvercle 34 par un jambage 52 et il est donc solidaire en rotation du carrousel 12. Lorsque le galet 50 arrive dans un secteur angulaire dans lequel la came 48 s'élève, le galet provoque donc le soulèvement du couvercle vers sa position haute. Au contraire, dans d'autres secteurs angulaires, le niveau de la came s'abaisse et le galet 50 permet alors au couvercle 34 de redescendre vers sa position de fermeture. Bien entendu, d'autres moyens de commande du déplacement du couvercle 34 sont envisageables sans sortir du cadre de l'invention.

De manière particulièrement avantageuse, le couvercle 34 n'a pas comme seule fonction d'assurer la fermeture étanche de la cavité 32. Il porte en effet des organes complémentaires.

Tout d'abord, le couvercle 34 porte des moyens de support du récipient. Dans l'exemple illustré, les récipients à traiter sont des bouteilles en matériau thermoplastique, par exemple en polyéthylène téréphtalate (PET). Ces bouteilles comportent une collerette en excroissance radiale à la base de leur col 58 de telle sorte qu'il est possible de les saisir à l'aide d'une fourchette 54 qui vient s'engager ou s'encliqueter autour du col, sous la collerette. Cette fourchette 54 est donc montée à l'extrémité inférieure d'une tige 56 qui traverse le couvercle 34. Cette tige 56 est mobile verticalement par rapport au couvercle de telle sorte que la bouteille 30 puisse être engagée sur la fourchette en étant légèrement écartée vers le bas par rapport au couvercle (figure 1). Une fois portée par la fourchette 54, la bouteille 30 peut être plaquée vers le haut contre une surface d'appui 60 du couvercle 34. De préférence, cet appui est étanche de telle sorte que, lorsque le couvercle est en position de fermeture, l'espace intérieur de la cavité 32 est séparé en deux parties par la paroi du récipient : l'intérieur et l'extérieur du récipient.

Cette disposition permet de ne traiter que l'une des deux surfaces (intérieure ou extérieure) de la paroi du récipient. Dans l'exemple illustré, on cherche à ne traiter que la surface interne de la paroi du récipient.

Ce traitement interne impose donc de pouvoir contrôler à la fois la pression et la composition des gaz présents à l'intérieur du récipient. Pour cela, l'intérieur du récipient doit pouvoir être mis en communication avec une source de dépression et avec un circuit de distribution de gaz. Le couvercle 34 comporte donc un injecteur 62 qui est agencé selon l'axe A1 et qui est lui aussi mobile par rapport au couvercle 34 entre une position haute escamotée pour laquelle le récipient 30 peut être amené radialement sur la fourchette 54 (Figure 1), et une position basse dans laquelle l'injecteur 62 est plongé à l'intérieur du récipient 30 (Figure 2).

Pour que le gaz injecté par l'injecteur 62 puisse être ionisé et former un plasma sous l'effet du champ électromagnétique créé dans l'enceinte, il est nécessaire que la pression dans le récipient soit de l'ordre de 10⁻⁴ bar. Pour mettre en communication l'intérieur du récipient avec une source de dépression (par exemple une pompe), le couvercle 34 comporte un canal interne 64 dont une terminaison principale 65 débouche dans la face inférieure du couvercle, plus précisément au centre de la surface d'appui 60 contre laquelle est plaqué le col de bouteille 30.

On remarque que dans le mode de réalisation proposé, la surface d'appui 60 n'est pas formée directement sur la face inférieure du couvercle mais sur l'extrémité annulaire inférieure d'une pièce rapportée tubulaire 61 d'axe A1 qui est fixée sous le couvercle 34. L'alésage interne de cette pièce tubulaire 61 constitue dans ce cas le prolongement de la terminaison principale 65. Ainsi, lorsque l'extrémité supérieure du col du récipient est en appui contre la surface d'appui 60, l'ouverture du récipient 30, qui est délimitée par cette extrémité supérieure, entoure complètement l'orifice par lequel la terminaison principale 65 débouche dans la face inférieure du couvercle 34.

Selon l'invention, cette terminaison principale 65 n'est pas liée directement aux moyens de pompage. En effet, du fait de la mobilité du couvercle 34, il faudrait alors prévoir des canalisations flexibles entre le couvercle et le circuit de pompage. Or, de telles canalisations sont peu adaptées dans un circuit de vide car une canalisation souple aura tendance à s'écraser sous l'effet de la pression atmosphérique.

Aussi, selon l'invention, le canal interne 64 du couvercle 24 comporte une extrémité de jonction 66 et le circuit de vide de la machine comporte une extrémité fixe 68 qui est disposée de telle sorte que les deux extrémités 66, 68 soient en regard l'une de l'autre lorsque le couvercle est en position de fermeture.

Dans l'exemple illustré, la paroi supérieure 36 de l'enceinte 14 présente un prolongement 70 qui s'étend dans le même plan horizontal, radialement vers l'intérieur par rapport à l'axe A0. Ce prolongement 70 est percé d'un orifice 72 et il comporte des moyens pour permettre le raccordement d'une canalisation 74 du circuit de vide. Cette canalisation 74 est par exemple reliée à une ou plusieurs pompes (non représentées). Ces pompes sont de préférence agencées à l'extérieur de la machine, et elles sont dans ce cas reliées à la canalisation 74 par l'intermédiaire d'un raccord tournant (non représenté) de manière à ne pas empêcher la rotation du carrousel.

De la sorte, étant donné que l'enceinte 14 est fixe par rapport au carrousel 12, la canalisation 74 peut être rigide ou très peu flexible.

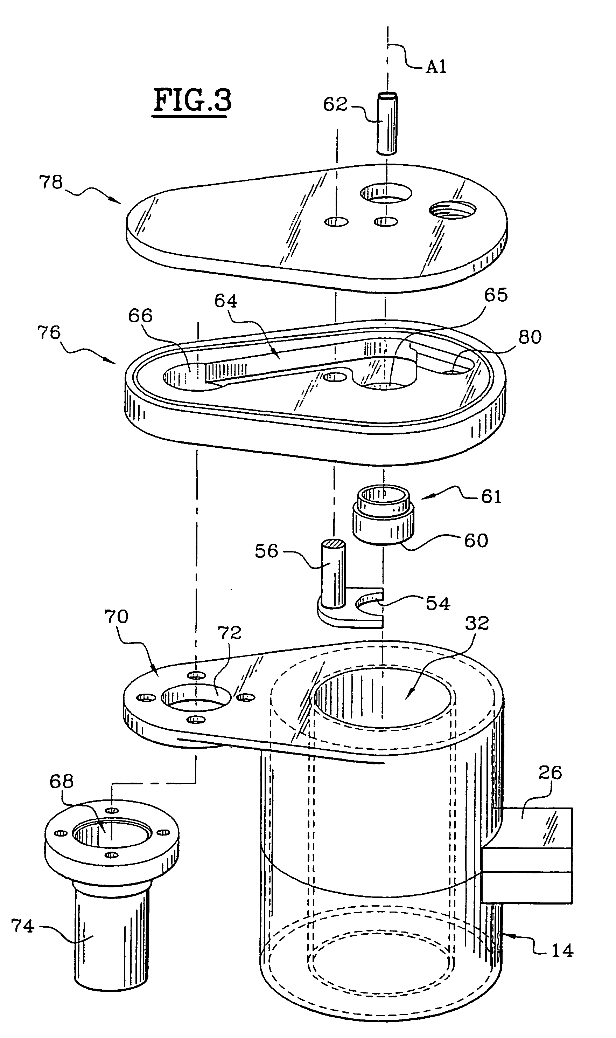

Comme on peut le voir sur la Figure 3, le couvercle 34 présente en vue de dessus la même forme que celle de la paroi supérieure de l'enceinte 14 et l'extrémité de jonction 66 débouche donc dans la face inférieure du couvercle 34, juste à l'aplomb de l'orifice 72 sur lequel est raccordée la canalisation 74.

Pour simplifier la réalisation du canal interne 64, le couvercle 34 est fabriqué en deux parties : une embase inférieure 76 et un capot supérieur 78. Le canal interne 64 est creusé dans la face supérieure à l'embase 76, seules l'extrémité de jonction 66 et la terminaison principale 65 débouchant dans la face inférieure. Ainsi, lorsque le capot 78 est plaqué de manière étanche sur l'embase, il n'y a plus de communication possible qu'entre l'extrémité de jonction 66 et la terminaison, si bien que le canal 64 assure une liaison étanche entre la canalisation 74 et la cavité 32.

La machine illustrée sur les figures est prévue pour traiter la surface interne de récipients qui sont en matière relativement déformable. De tels récipients ne pourraient pas supporter une surpression de l'ordre de 1 bar entre l'extérieur et l'intérieur de la bouteille. Ainsi, pour obtenir à l'intérieur de la bouteille une pression de l'ordre de 10⁻⁴ bar sans déformer la bouteille, il faut que la partie de la cavité 32 à l'extérieur de la bouteille soit, elle aussi, au moins partiellement dépressurisée. Aussi, le canal interne 64 du couvercle 34 comporte, en plus de la terminaison principale 65, une terminaison auxiliaire 80 qui débouche elle aussi au travers de la face inférieure du couvercle, mais radialement à l'extérieur de la surface annulaire d'appui 60 sur laquelle est plaquée le col 58 du récipient.

Ainsi, les mêmes moyens de pompage créent simultanément le vide à l'intérieur et à l'extérieur du récipient.

Pour limiter le volume de pompage, et pour éviter l'apparition d'un plasma inutile à l'extérieur de la bouteille, il est préférable que la pression à l'extérieur ne descende pas en dessous de 0,05 à 0,1 bar, contre une pression de 10⁻⁴ bar à l'intérieur. On constate de plus que les bouteilles, même à parois minces, peuvent supporter cette différence de pression sans subir de déformation notable. Pour cette raison, il est prévu de munir le couvercle d'une soupape commandée 82 pouvant obturer la terminaison auxiliaire 80.

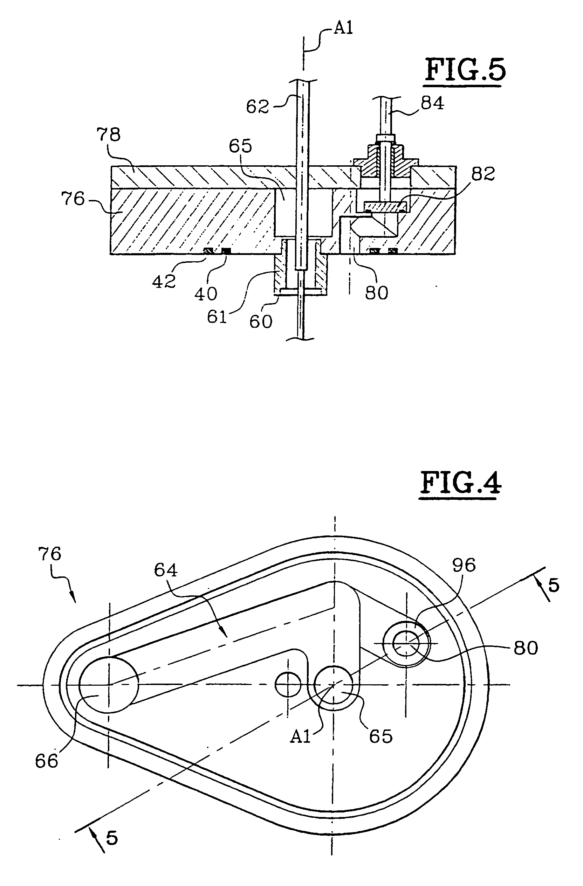

Comme on peut le voir sur les Figures 4 et 5, la soupape 82 est emprisonnée dans le couvercle 34, entre l'embase 76 et le capot 78, et elle est du type « normalement fermée ». La soupape 82 est agencée à l'extrémité inférieure d'une tige de soupape 84 qui vers le haut au travers du capot 78 du couvercle 34.

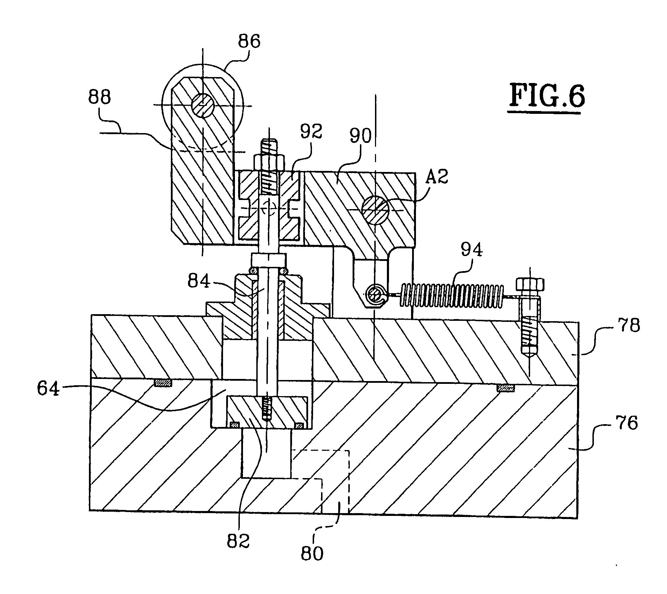

Comme on peut le voir plus en détail à la Figure 6, la tige de soupape 84 est commandée par un système à galet 86 qui est destiné à coopérer avec une came 88 fixe de la machine. En un point donné de la rotation du carrousel, la came 88 provoque le soulèvement du galet 86 qui est solidaire d'un levier 90 articulé autour d'un axe horizontal A2 sur le couvercle 34. Le galet provoque donc un pivotement du levier 90, lequel provoque le soulèvement de la tige 84 par l'intermédiaire d'une noix de commande 92. Lorsque la came 88 permet au galet de redescendre, un ressort de rappel 94, qui agit entre le couvercle 34 et le levier 90, tend à ramener la tige de soupape 84 vers le bas pour plaquer la soupape 82 contre un siège de soupape 96 formé autour de la terminaison auxiliaire 80.

Bien entendu, d'autres moyens de commande de la soupape 82 pourraient être prévus sans sortir du cadre de l'invention. On pourrait ainsi utiliser par exemple un vérin ou un électroaimant.

Le fonctionnement du dispositif qui vient d'être décrit peut donc être le suivant.

En un point donné de la rotation du carrousel, le couvercle 34 est en position haute. La fourchette 54 est en position basse et l'injecteur est en position escamotée haute tel que cela est illustré sur la figure 1. Un récipient 30 peut donc être amené en ce point sur la fourchette 54, par exemple grâce à une roue de transfert à encoches. De telles roues sont largement connues et utilisées dans les machines de fabrication et de remplissage de bouteilles en PET. Cette roue serait alors tangente au carrousel au point de chargement du récipient.

Une fois le récipient chargé sur la fourchette 54, le carrousel 12 poursuivant son mouvement de rotation, le couvercle s'abaisse vers sa position de fermeture. Dans le même temps, la tige 56 qui porte la fourchette 54 est commandée pour plaquer le récipient de manière étanche contre la surface d'appui 58 du couvercle 34 et l'injecteur 62 est abaissé pour plonger à l'intérieur du récipient. On remarque d'ailleurs que l'injecteur s'abaisse au travers de la terminaison principale 65 du canal 64 mais qu'il ne l'obture pas.

Une fois le couvercle en position de fermeture, il est possible d'aspirer l'air contenu dans la cavité 32 laquelle se trouve reliée au circuit de vide grâce au canal interne 64 du couvercle 34.

Dans un premier temps, la soupape 82 est commandée pour être ouverte si bien que la pression chute dans la cavité 32 à la fois à l'extérieur et à l'intérieur du récipient. Lorsque le carrousel 12 atteint une position angulaire prédéterminée, on considère que le niveau de vide à l'extérieur du récipient a atteint un niveau suffisant et le système à came 88 et à galet 86 commande la fermeture de la soupape 82. Il est alors possible de continuer le pompage exclusivement à l'intérieur du récipient 30.

Une fois la pression de traitement atteinte, le traitement peut commencer. Ce traitement peut par exemple consister en un dépôt d'un revêtement interne, ce dépôt étant obtenu du fait de l'ionisation sous forme de plasma d'un gaz précurseur injecté dans le récipient grâce à l'injecteur 62.

Une fois le traitement achevé, la remise de la cavité à la pression atmosphérique sera avantageusement réalisée au travers du canal interne 64 du couvercle. On peut alors choisir de le faire en reliant la canalisation 74 à la pression atmosphérique ou on peut choisir de munir le canal 64 d'une ouverture commandée (non représentée) permettant de relier directement le canal à l'atmosphère. Dans les deux cas, on veillera d'abord à commander l'ouverture de la soupape 82 pour que la pression atmosphérique soit rétablie simultanément à l'extérieur et à l'intérieur du récipient.

Une fois l'équilibre de pression atteint entre l'extérieur et l'intérieur du récipient, il est possible de commander le couvercle vers sa position haute, d'escamoter l'injecteur et de décaler la fourchette 54 vers le bas par rapport au couvercle 34 pour permettre l'évacuation du récipient traité.

Grâce à l'invention, le circuit de vide de la machine peut être conçu de manière économique et fiable car il ne fait pas appel, au niveau du couvercle, à des systèmes de flexibles qui seraient sollicités de manière répétitive et qui pourraient donc se rompre.

## Revendications

1. Dispositif pour le traitement d'un récipient (30) à l'aide d'un plasma à basse pression qui est créé par excitation d'un gaz grâce à des ondes électromagnétiques, du type comportant au moins un poste de traitement (14) comprenant une cavité fixe (32) prévue pour recevoir le récipient (30) à traiter, la cavité (32) étant destinée à être reliée à une source de dépression par l'intermédiaire d'un circuit de vide (74), du type dans lequel le poste de traitement (14) comporte un couvercle mobile (34) qui permet de fermer la cavité (32) de manière étanche, et du type dans lequel l'introduction du récipient dans la cavité (32) avant le traitement et son extraction après le traitement sont assurés par déplacement du couvercle (34) par rapport à la cavité (32),
**caractérisé en ce que** le couvercle (34) comporte un canal de liaison (64) qui, lorsque le couvercle (34) est en position de fermeture étanche de la cavité (32), met en communication la cavité (32) avec une extrémité fixe (68) du circuit de vide (74).

2. Dispositif selon la revendication 1, **caractérisé en ce que** le canal de liaison (64) comporte une extrémité de jonction (66), qui coopère avec l'extrémité fixe (68) du circuit de vide, et deux terminaisons (65, 80) qui débouchent dans une face intérieure du couvercle (34) qui délimite la cavité lorsque le couvercle est en position de fermeture, et **en ce que** des moyens de support (54) sont prévus pour plaquer de manière étanche une ouverture du récipient à traiter (58, 30) contre ladite face intérieure (60) du couvercle (34), l'ouverture entourant complètement une première des dites terminaisons de manière que le récipient (30) délimite dans la cavité (32) une première partie reliée au circuit de vide par la première terminaison (65) et une seconde partie reliée au circuit de vide par la seconde (80) des dites terminaisons.

3. Dispositif selon la revendication 2, **caractérisé en ce que** l'une des deux terminaisons (65, 80) comporte un obturateur (82) commandé pour pouvoir séparer de manière étanche les deux parties de la cavité lorsque le couvercle (34) est en position de fermeture.

4. Dispositif selon la revendication 3, **caractérisé en ce que** l'obturateur est une soupape commandée (82).

5. Dispositif selon l'une quelconque des revendications 2 à 4, **caractérisé en ce que** la première terminaison (65) du canal de liaison (64) permet le passage d'un injecteur (62) pour amener un gaz réactif à l'intérieur du récipient (30).

6. Dispositif selon l'une quelconque des revendications précédentes, **caractérisé en ce que** le canal de liaison comporte un orifice de reprise d'air qui débouche à l'air libre et qui est muni d'un volet d'obturation commandé pour pouvoir relier la cavité (32) à l'atmosphère en fin de traitement.

7. Dispositif selon l'une quelconque des revendications précédentes, **caractérisé en ce que** le couvercle (34) comporte des moyens de support (54) du récipient (30).

## Patentansprüche

1. Vorrichtung zur Behandlung eines Behälters (30) mit Hilfe eines Niederdruckplasmas, das durch Erregung eines Gases mit Hilfe von elektromagnetischen Wellen erzeugt wird, von der Art, die mindestens eine Behandlungsstation (14) aufweist, die einen ortsfesten Hohlraum (32) enthält, der vorgesehen ist, um den zu behandelnden Behälter (30) aufzunehmen, wobei der Hohlraum (32) dazu bestimmt ist, über einen Vakuumkreislauf (74) mit einer Unterdruckquelle verbunden zu werden, von der Art, bei der die Behandlungsstation (14) einen beweglichen Deckel (34) aufweist, der es ermöglicht, den Hohlraum (32) dicht zu verschließen, und von der Art, bei der die Einführung des Behälters in den Hohlraum (32) vor seiner Behandlung und seine Entnahme nach der Behandlung durch Verschiebung des Deckels (34) bezüglich des Hohlraums (32) gewährleistet werden, **dadurch gekennzeichnet, dass** der Deckel (34) einen Verbindungskanal (64) aufweist, der, wenn der Deckel (34) in der Stellung des dichten Verschließens des Hohlraums (32) ist, den Hohlraum (32) mit einem ortsfesten Ende (68) des Vakuumkreislaufs (74) in Verbindung setzt..

2. Vorrichtung nach Anspruch 1, **dadurch gekennzeichnet, dass** der Verbindungskanal (64) ein Anschlussende (66), das mit dem ortsfesten Ende (68) des Vakuumkreislaufs zusammenwirkt, und zwei Enden (65, 80) aufweist, die in eine Innenfläche des Deckels (34) münden, die den Hohlraum begrenzt, wenn der Deckel in der Schließstellung ist, und dass Haltemittel (54) vorgesehen sind, um eine Öffnung des zu behandelnden Behälters (58, 30) dicht gegen die Innenfläche (60) des Deckels (34) zu drücken, wobei die Öffnung eines der Enden vollständig umgibt, so dass der Behälter (30) im Hohlraum (32) einen ersten Bereich, der mit dem Vakuumkreislauf über das erste Ende (65) verbunden ist, und einen zweiten Bereich begrenzt, der mit dem Vakuumkreislauf über das zweite Ende (80) verbunden ist.

3. Vorrichtung nach Anspruch 2, **dadurch gekennzeichnet, dass** eines der beiden Enden (65, 80) ein Verschlussorgan (82) aufweist, das so gesteuert wird, dass die beiden Bereiche des Hohlraums dicht voneinander getrennt werden können, wenn der Deckel (34) in der Schließstellung ist.

4. Vorrichtung nach Anspruch 3, **dadurch gekennzeichnet, dass** das Verschlussorgan ein gesteuertes Ventil (82) ist.

5. Vorrichtung nach einem der Ansprüche 2 bis 4, **dadurch gekennzeichnet, dass** das erste Ende (65) des Verbindungskanals (64) den Durchgang eines Injektors (62) erlaubt, um ein reaktives Gas ins Innere des Behälters (30) zu bringen.

6. Vorrichtung nach einem der vorhergehenden Ansprüche, **dadurch gekennzeichnet, dass** der Verbindungskanal eine Luftaufnahmeöffnung aufweist, die in der Umgebungsluft mündet und die mit einer Verschlussklappe versehen ist, die gesteuert wird, um den Hohlraum (32) am Ende der Behandlung mit der Atmosphäre verbinden zu können.

7. Vorrichtung nach einem der vorhergehenden Ansprüche, **dadurch gekennzeichnet, dass** der Deckel (34) Mittel (54) zum Halten des Behälters (30) aufweist.

## Claims

1. Device for treating a receptacle (30) with a low-pressure plasma created by energizing a gas using electromagnetic waves, of the type comprising at least one treatment station (14) comprising a fixed cavity (32) designed to accommodate the receptacle (30) that is to be treated, the cavity (32) being intended to be connected to a vacuum source via a vacuum circuit (74), of the type in which the treatment station (14) comprises a moving lid (34) that allows the cavity (32) to be sealed closed, and of the type in which the receptacle is introduced into the cavity (32) before treatment and extracted after treatment by moving the lid (34) with respect to the cavity (32),
**characterized in that** the lid (34) comprises a connecting duct (64) which, when the lid (34) is in the position in which the cavity (32) is sealed closed, places the cavity (32) in communication with a fixed end (68) of the vacuum circuit (74).

2. Device according to Claim 1, **characterized in that** the connecting duct (64) has a connecting end (66) which collaborates with the fixed end (68) of the vacuum circuit, and two terminations (65, 80) which open into an interior face of the lid (34) which delimits the cavity when the lid is in the closed position, and **in that** support means (54) are provided so that an opening of the receptacle that is to be treated (58, 30) is pressed in a sealed manner against the said interior face (60) of the lid (34), the opening completely surrounding a first of the said terminations so that the receptacle (30) delimits, within the cavity (32), a first part connected to the vacuum circuit by the first termination (65) and a second part connected to the vacuum circuit via the second (80) of the said terminations.

3. Device according to Claim 2, **characterized in that** one of the two terminations (65, 80) comprises a shutter (82) controlled in such a way as to be able to separate the two parts of the cavity in a sealed manner when the lid (34) is in the closed position.

4. Device according to Claim 3, **characterized in that** the shutter is a controlled valve (82).

5. Device according to any one of Claims 2 to 4, **characterized in that** the first termination (65) of the connecting duct (64) allows the passage of an injector (62) so as to convey a reactive gas into the receptacle (30).

6. Device according to any one of the preceding claims, **characterized in that** the connecting duct comprises an air intake orifice which opens to the open air and is equipped with a shut-off flap that is controlled so that the cavity (32) can be connected to the atmosphere at the end of the treatment.

7. Device according to any one of the preceding claims, **characterized in that** the lid (34) comprises support means (54) for supporting the receptacle (30).
